# EUROPEAN PATENT APPLICATION

(11) **EP 2 079 032 A1**
(43) Date of publication of application: **15.07.2009**
(21) Application number: 08171388.5
(22) Date of filing: 11.12.2008
(51) Int. Cl.: G06F 17/50

(54) **Interconnect architectural state coverage measurement methodology**

(30) Priority: 27.12.2007 US 965158
(71) Applicant: Intel Corporation, Santa Clara, CA 95054 (US)
(72) Inventor: Mannava, Phanindra, Folsom, CA 95630 (US); Park, Seungjoon, Los Altos, CA 94024 (US); Dingankar, Ajit, El Dorado Hills, CA 95762 (US); Chou, Ching-Tsun, Palo Alto, CA 94306 (US); Mittal, Nikhil, 560008, Bangalore (IN)
(74) Representative: Hutchinson, Glenn Stanley

(57) **Abstract**

A method and apparatus for ensuring efficient validation coverage of an architecture, such as protocol or interconnect architecture, is herein described. A coverage space of states for an architecture is generated and stored in a database. During simulation, states of the coverage space encountered are marked. From this, the states encountered and not encountered may be determined. Based on the states not encountered, a targeted test suite is developed to target at least some of the states not encountered during previous simulation. This feedback loop from simulation to refining of a test suite based on states of a coverage space not encountered during simulation may be recursively repeated until adequate validation, i.e. an adequate confidence level of validation, of the coverage space is achieved.

## Description

### FIELD

This invention relates to the field of computer systems and, in particular, to validation methodology of protocols.

### BACKGROUND

Advances in semi-conductor processing and logic design have permitted an increase in the amount of logic that may be present on integrated circuit devices. In addition, computer systems have evolved to encompass numerous different functions, such as traditional computing systems, media storage systems, entertainment centers, audio playback, video playback, servers, etc. Furthermore, high performance protocols have been designed to transfer information throughout a computer system for this faster and more expansive functionality. As an example, Intel's Quickpath Architecture includes a highspeed, cache coherent, serial point-to-point layered protocol protocol architecture capable of transmitting data at high rates. However, as these more advanced protocols continue to evolve, the complexity of each layer of an protocol architecture also increases.

Traditionally, validation of a protocol architecture to ensure correct operation involves manual identification of corner cases, i.e. extreme operating points or states. These corner cases are induced in a system to validate operation of the protocol implementation. In the alternative or sometimes in addition to corner cases, random operating variables/states are altered to randomly validate the protocol architecture.

However, these parameters and variables are becoming extremely large in number as complexity increases. For example, with a complex protocol having multiple agents, the number of potential states grows exponentially. As a result, it becomes more difficult for a person to contemplate a coverage space for the potential states. In addition, current methods of validation are often not able to track which of the large number of states are validated. Consequently, an accurate confidence level in the amount of an architecture validated becomes even more difficult to obtain.

### BRIEF DESCRIPTION OF THE DRAWINGS

The present invention is illustrated by way of example and not intended to be limited by the figures of the accompanying drawings.

Figure 1 illustrates an embodiment of a system including different interconnects to couple components of the system together.

Figure 2 illustrates an embodiment of a storage medium to hold a coverage space database for a configuration of an architecture.

Figure 3 illustrates an embodiment of a flow diagram for a method of ensuring validation coverage for an architecture.

Figure 4 illustrates an embodiment of a flow diagram for another method of ensuring validation coverage for an interconnect architecture.

### DETAILED DESCRIPTION

In the following description, numerous specific details are set forth such as examples of specific protocol architectures, specific protocol operating variables/parameters, specific models, specific validation steps etc. in order to provide a thorough understanding of the present invention. It will be apparent, however, to one skilled in the art that these specific details need not be employed to practice the present invention. In other instances, well known components or methods, such as interconnect protocols/implementation, formal interconnect model development/content, specific queries, and other specific operational details, have not been described in detail in order to avoid unnecessarily obscuring the present invention.

The method and apparatus described herein are for providing a validation strategy to effectively and efficiently validate an implementation of a complex protocol. Specifically, validation of interconnect protocols is primarily discussed in reference to a cache coherence interconnect protocol, such as a high speed point to point interconnect including a cache coherence protocol substantially adhering to Intel's Quickpath specification, to illustrate the validation methodology. However, the methods and apparatus described herein are not so limited, as they may be implemented on or in association with any protocol, interconnect architecture layer, or other multiple agent/parameter system.

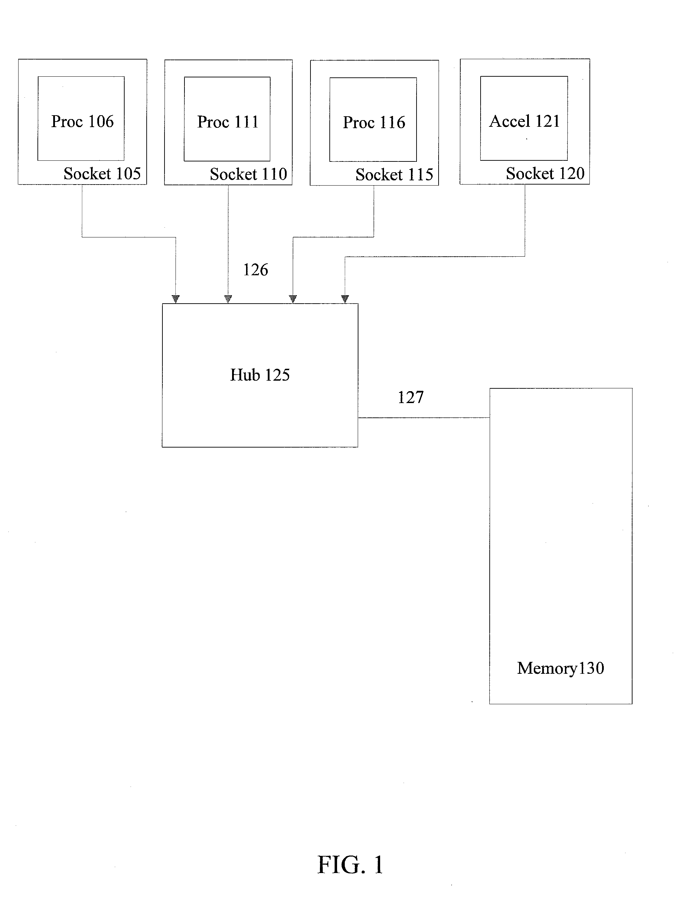

Referring to **Figure 1****,** an embodiment of multiple interconnects to couple components of a system is illustrated. As illustrated, a portion of a traditional multiprocessor system is depicted. However, the validation methodology described herein may be utilized in any system, such as single processor computer systems, servers, embedded systems, mobile systems, and other systems having multiple electrical agents.

In one embodiment, hub **125** resembles a chipset. Often a chipset comprises two integrated circuit devices, such as a memory controller hub (MCH) and an interconnect controller hub (ICH). In one embodiment Hub **125** is the MCH coupling processors **106, 111, 116,** and **121,** to memory **130.** However, hub **125** may include any integrated circuit for facilitating communication between processors and other system devices.

Memory **130,** as illustrated includes a system memory, to hold code, data, and other information to be accessed during runtime. An example of system memory includes dynamic random access memory (DRAM). However, any memory may be utilized for system memory, such as double data rate (DDR) memory, synchronous dynamic RAM (SDRAM), buffered memory, and other known memory devices. Additionally, memory 130 is not limited to a system memory, and may include other known memory devices, such as a flash memory device.

Processor sockets **105, 110, 115,** and **120** are for coupling processors **106, 111, 116,** and **121** to a circuit board, such as a Printed Circuit Board (PCB) or motherboard. Often a socket and corresponding packaging technology, such as Land Grid Array (LGA), Pin Grid Array (PGA), a Ball Grid Array (BGA), or other known socket technology, is utilized. Processors **106, 111, 116,** and **121** are often referred to as physical processors, but may include any style of processing element, such as a microprocessor, an embedded processor, a multi-core processor, a mutli-threaded processor, or a signal processor.

Interconnect **126,** as illustrated, couples processors **106, 111, 116,** and **121** to hub **125.** Often interconnect **126** is referred to as a Front Side Bus (FSB). Although, validation is discussed in reference to interconnect **126** and protocols thereof, note that the validation methodology discussed herein may be utilized on any interconnect, such as an I/O interconnect, memory bus, or other link coupling agents together that implement any number and style of communication protocol. Physically, interconnect **126** may utilize a parallel bus, a serial bus, a multi-drop bus, a point-to-point bus, a Gunning Transceiver Logic (GTL) bus, a GTL+ bus, a double data rate (DDR) bus, a differential bus, or other known physical layer/implementation of an interconnect. As a specific illustrative embodiment, interconnect **126** includes a high speed serial point-to-point interconnect.

In one embodiment, interconnect **126** includes a layered protocol stack architecture. Exemplary layers of an interconnect architecture includes a physical layer to provide physical electrical connection between devices, a link layer to assist in sequencing of transactions/requests/packets, and a transaction layer to implement different styles of transactions/requests/packets. These layers are common in an interconnect architecture, such as a Peripheral Component Interconnect (PCI) Express. However, other layers or protocols may be present as part of an interconnect architecture. For example, an interconnect architecture substantially adhering to Intel's Quickpath specification includes different transaction and communication protocols, such as cache coherence protocol.

As stated above, the validation of protocols for interconnects may include any interconnect in a platform, such as an Input/Output (I/O) bus, a Peripheral Component Interconnect (PCI) or a PCI Express bus, or a memory bus, such as memory bus **127.** Common examples of a physical memory bus to connect hub **125** to memory **130** include a DDR based bus, a Random Access Memory (RAM) based bus, or any other known memory bus or other bus adapted for a memory bus. Each style of bus may be associated with their own communication protocols to be validated.

Furthermore, the validation methodology for protocols is not limited to protocols of traditional desktop computer system interconnects. For example, network protocols, wireless access protocols, and other complex communication protocols may be validated in a similar manner. Therefore, whether validation is to be of a physical interconnect, an interconnect protocol, or other protocol, the target of validation may be referred to as an architecture, a validation object, and a validation target.

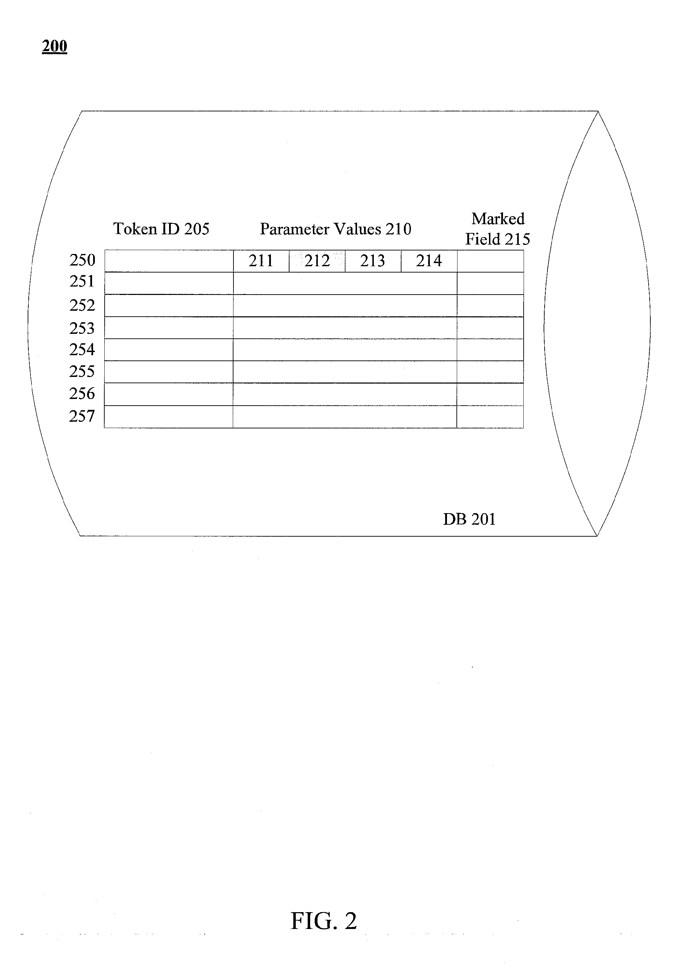

Referring to **Figure 2****,** an embodiment of a coverage database for a coverage space of possible states of an architecture to be validated is illustrated. Note, as stated above, use of the term architecture to be validated may refer to a protocol architecture to be validated, such as a cache coherence protocol to be validated, other protocol to be validated, a physical interconnect to be validated, or validation of a combination thereof.

In one embodiment, database **201** is held in storage medium **200.** A storage medium includes any storage device capable of holding electronic information, such as a disc, disk drive, a memory, a tape drive, external storage, temporary memory, volatile memory, non-volatile memory, other storage device, or a machine accessible/readable medium. Note that a machine accessible medium may include carrier wave or other electronic transmission medium, which carries or transmits information, such as the information held in database **201,** from a storage medium to a computer system to be accessed.

In one embodiment, a coverage space database for an architecture includes a plurality of states for an architecture, such as a protocol architecture, may encounter during operation. As an example, a coverage database includes all potential states of an implementation of an architecture, such as a configuration constrained model of an architecture. However, in another example, a coverage database includes a reduced set of possible states of an architecture implementation.

For example, assume a formal model of a protocol layer of an interconnect is tailored to an implementation specific protocol model for the interconnect. Here, when variables/parameters are varied to achieve different states within the implementation specific protocol, each set of variables may potentially have a symmetric set of variables resulting in symmetric states. As a result, in this example, only one symmetric state is retained in database **201** forming a symmetrically reduced set of interconnect states, which may also generally be referred to as a coverage space.

As an oversimplified example of a coverage space for validation, a formal model for a cache coherence protocol of a cache coherent interconnect is tailored based on configuration constraints, such as a number of protocol agents, type of protocol agents, etc. The coverage space for validation of the cache coherence protocol includes all of the possible states or a symmetrically reduced set of the possible states based on varied agent parameters for each of the protocol agents and/or for varied global parameters for the coherency protocol.

However, for complex protocols or interconnects, the number of parameters potentially grows to a considerable number. For example, there may be as many as 100 or more parameters for a specific protocol implementation. Consequently, each combination of different values for each parameter potentially results in an extremely large number of possible states; even for a specific implementation of a protocol.

In one embodiment, a state refers to a snapshot of states of parameters, devices, agents, and/or other components of a validation object. A state may also be referred to as an architectural state of an architecture or validation object. As another example, a state is defined by the combination of the values of parameters at the snapshot of the state. Consequently, if one hundred parameters are identified for an architecture, then every combination of different values for those one hundred parameters potentially result in different states.

As a state often refers to a large number of parameters for a complex protocol, an oversimplified illustrative example of a state for a cache coherence protocol includes one processor holding a cache line in a shared coherence state, two processors holding the cache line in an invalid state, and a snoop is received at one of the processors. Here, there are multiple protocol agents, multiple cache lines held in multiple states, and a request/message received at a specific destination. Therefore, in this simple example alone, there are quite a few parameters. As another illustrative example, a write transaction carrying a data payload potentially results in multiple states, as other parameters, such as the destination of the write, state of cache lines associated with the data payload to be written, interconnect traffic, write responses by other agents, etc. may be varied.

Therefore, a parameter, in one embodiment, refers to any element within a protocol, physical logic, device, agent, or global state/variable that may be varied or placed in different states. As a specific example, when validating a cache coherence protocol, a parameter for a caching agent includes a cache response to a snoop. Here, one value of a cache response parameter includes forwarding the snooped cache line to the requesting device and a second value of the cache response parameter includes writing the cache line to a home node. Other common coherency protocol parameters include different types of agents, agent responses, device responses, interconnect responses, message responses, types of responses, other responses to specific actions, response destinations, messages, types of messages, message destinations, requests, types of requests, request destinations, types of caches, cache states, cache locations, register states, etc.

However, as any architecture, such as physical interconnect, communication protocol, or other protocol may be an object of validation, a parameter may encompass a wide variety of variables. A non-exhaustive illustrative list of potential protocol related parameters include a number of protocol agents, a type of protocol agent, a type of cache implementation for an agent, numbers of protocol agents of varying types, a style of protocol agent, a state of an protocol agent, a state of circuitry or state machine in an protocol agent or on the bus, an agent identifier, a number of protocol requests, a request type, a request source, a request destination, a state of a request, an operation referenced, a source of an operation, an address referenced, an address accessed, a state of an address location, a data payload, a state of an protocol agent, a state of a cache, a state of a cache line, and a physical protocol state parameter, such as a voltage, frequency, power state, or other physical protocol attribute.

When a physical layer of an interconnect is to be validated, a few examples of physical parameters of an interconnect include voltage, frequency, period, spread-spectrum, jitter, noise, etc, while other parameters include the state of interconnect related state machines, types of agents, states of agents, states of I/O circuitry in agents, etc. However, any variable element within an architecture may be considered a parameter.

As coverage spaces grow exponentially and become difficult for a person to comprehend, in one embodiment, data base **201** holds a coverage space of possible states for an interconnect architecture/implementation. As illustrated, each entry of data base **201,** such as entries **250-257,** represent a possible state of an interconnect implementation. Therefore, reference to entry **250** is synonymous with discussion of state **250** having parameter values as defined in field **210.** Here, parameter values field **210** of entry **250** is to hold numerical values for associated parameters corresponding to state **250.**

In one embodiment, parameter value field **210** is split into plurality of fields **211, 212, 213,** and **214.** As an example, assume database **201** is to hold a coverage space for an implementation of a coherency protocol having three protocol agents. Here, fields **211-213** correspond to each of the three protocol agents. Within each field, each numerical value, which may be logically viewed as a sub-field, is predefined or pre-associated with a corresponding parameter.

For example, in field **211** for the first agent, the first numerical value of field **211** defines the type of agent, the second numerical value defines whether the first agent is a home node, a third numerical value defines a state of a cache line, etc. Note that a response to a specific request/action, such as a response to a snoop/read, potentially has numerous variances. For example, a response with four different responses is potentially represented by two binary bits with four possible combinations, i.e. one, two, three, and four; each of the combination representing a possible response.

Furthermore, field **214** may be a global parameter field including global parameters for all of the agents. For example, a global cache response to a snoop may be to forward to a home node, and as such, a parameter value in field **214** represents that cache response. The examples above are purely illustrative, as any number of agents and any number of parameters, such as tens, hundreds, or thousands, may be represented in field **210** in any form. Additionally, above any known method of representing varied elements may be utilized in field **210.**

In another embodiment, field **210** holds a plurality of sequential values, and a predefined structure of the numerical values within field **210** associates each parameter value with a corresponding parameter. As an example, a first number in field **210** represents the number of total agents, a second number represents a number of caching agents, a third number represents a response by a first agent to a request, a fourth number represents a response by a second agent to the request, and so on. As can be seen, here, instead of breaking out parameters by agent, parameters are listed sequentially. However, any design implementation or form of representing parameters may be utilized in database **201.**

As the complexity of interconnects grow and the number of variables/parameters increase, the number of states to be held in database **201** also greatly increases. Therefore, in one embodiment, each entry includes token identifier field **205** to uniquely identify each entry. For example, the numerical parameter values that are held in field **210** define state **250,** i.e. entry **250,** and token ID **205** for entry **250** is based on the numerical values held in field **210** of entry **250.**

As a first example, the numerical values are combined utilizing a mathematical algorithm to obtain the corresponding token ID. Therefore, if one hundred numerical values are held in parameter field **210,** then the one hundred values or some portion thereof, are combined in each entry **250-257** to obtain unique token IDs **205** for each entry **250-257.** Note as the parameters are varied through different numerical values, the token ID will change based on the change in parameter values in fields **210.** For example, when a response to a snoop parameter is changed from a first response, which we assume is represented as 0, to a second response, which we assume is represented as 1, the token identifier also changes based on the mathematical combination of the numerical parameter values. Any algorithm may be utilized to combine the numerical parameter values into a token ID.

In one embodiment, each entry **250-257** also includes marking field **215.** Marking field **215** when holding a first value, such as an unmarked value, represents that the corresponding state has not been encountered during simulation. For example, when marking field **215** is unmarked, entry **250,** i.e. state **250,** has not been encountered during simulation. In contrast, when marking field **215** of entry **250** is updated to a marked value, then state **250** has been encountered during simulation. Therefore, by marking during simulation, it is possible to later determine which states have been visited/encountered during simulation, and which states have not been encountered.

As a consequence, a coverage space for a validation object, such as a protocol, physical interconnect, other layer, or architecture, is generated and potentially utilized for validation. In one embodiment, database **201** is generated and provided on or through a storage medium for later validation. Here, any level of implementation for the validation object may be defined for generation of the coverage space, i.e. the possible states held in database **201.**

For example, a formal mode of an interconnect architecture may be filtered to an implementation specific model. Depending on the constraints of the implementation specific model, the number of states in database **201** are varied. For example, if a first model only defines a number of protocol agents, then the coverage space may be extremely large as many other parameters may still be varied. In contrast, if the model defines the number of agents, types of agents, interconnect of agents, certain protocol restraints, then the coverage space may be reduced. In addition, when a model checker is executed to explore the possible states of a validation object, then either a full set or reduced set of the states is stored into entries of database **201.** Database **201** may then be provided to another user, such as a customer, to enable validation of the protocol, interconnect, or other validation object. Validation methodology for validating an interconnect architecture utilizing a database similar to database **201** is discussed below.

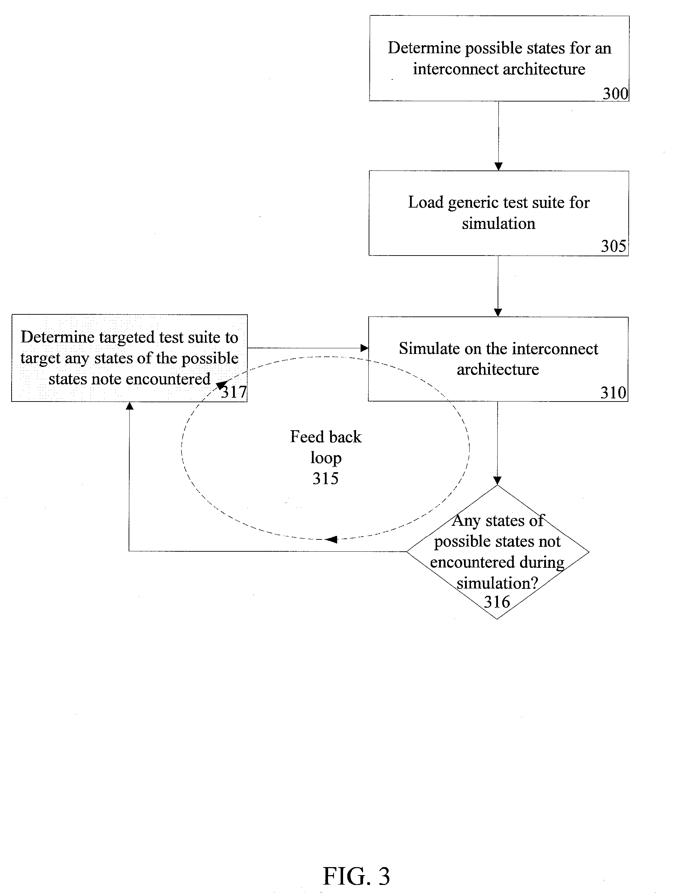

Turning to **Figure 3****,** an embodiment of a flow diagram for a method of ensuring architectural state coverage during validation of an architecture, such as a protocol architecture, a physical interconnect architecture, an interconnect protocol architecture, or other architectural system, is depicted. Although the flows of **Figures 3-4** are illustrated as substantially serial and in a specific order, any of the flows may be performed in parallel or in another order. For example, marking in flow **430** often takes place during simulation **425,** but may also take place after simulation. Furthermore, simulation of a generic test suite may be done in parallel or completely separate from flows **405-415.**

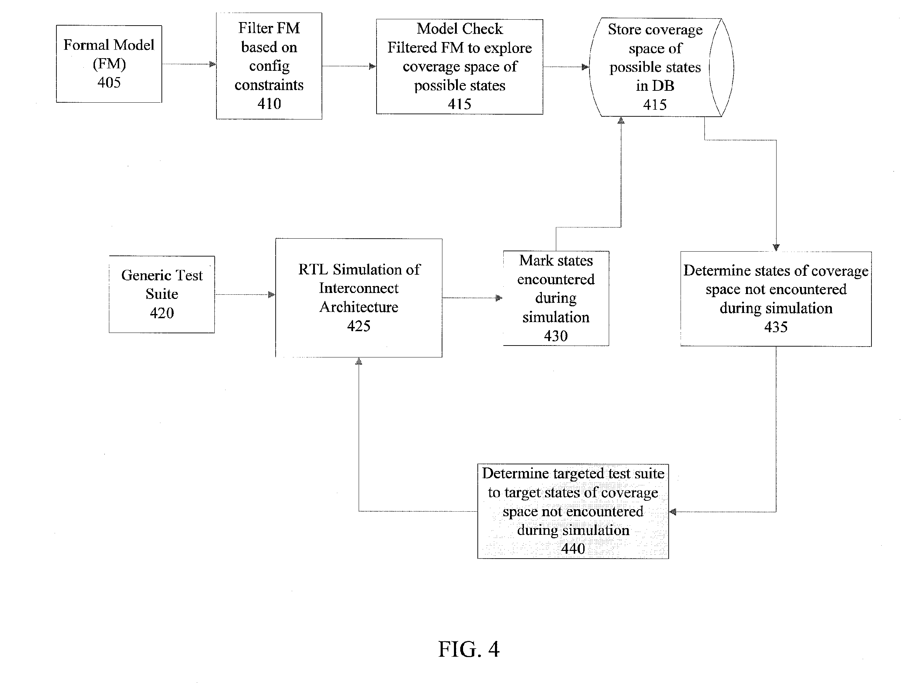

Also note that any of the flows may be performed as a result of execution of code from a machine accessible or readable medium. A machine accessible or readable medium, such as an article of manufacture, is discussed in more detail below. Therefore, a compiler, a parser, or other executable code, when executed, may insert instructions, operations, function call, and other executable code or structures, to perform operations illustrated in the following flows. Furthermore, in one embodiment, each of the flows discussed in reference to **Figures 3** **and** **4** may be automated. In one embodiment, automated includes execution of scripts, parsers, or other code to perform the task(s) in a flow. Moreover, master code or other code itself may call or cause the next flow, which may also be automated, to be performed.

In flow **300** possible states for a validation object, such as an interconnect architecture, protocol architecture, or other known target of state or variable validation, are determined. As stated above, in one embodiment, possible states refer to states of an architecture that may be encountered during operation. Here, a possible state refers to a snapshot of parameters, variables, circuit and state machine states, as well as any other discussed or known parameter.

For example, a combination of specific values of identified parameters for an interconnect architecture may result in a single interconnect architecture state. To illustrate, in a coherence protocol, a simplified exemplary state includes three protocol agents, one agent holding a cache line in an owned state, two agents holding it in an invalid state, a global response for a snoop to write to a home node, and a snoop is received.
Here, the coherence protocol is in a specified state. However, note when other variables/parameters, not listed, are included and varied, those specified parameters essentially form a query. The query may logically view a subset space of the possible states, i.e. the states having the specified parameters from above with other parameters varied.

In one embodiment, a formal model of an interconnect architecture is filtered or tailored to an implementation specific model. Here, a formal model may embody a specification of an architecture/protocol, such as a full formal model of constraints for a coherence protocol to be implemented. In one embodiment, the formal model includes a formal model of a coherence protocol that substantially adheres to Intel's Quickpath specification. However, a formal model may include any modeling of a protocol, architecture, interconnect, interconnect layer, or other validation object. In one embodiment, database **201** is to hold a coverage space of states for the formal model.

However, within a full specification, a specific implementation of the interconnect architecture may be utilized. As a result, the formal model may be filtered, tailored, and/or modified based on specific configuration constraints of the specific implementation. For example, in a coherence protocol, the number of agents may be specified, as well as the type of agents or other information. Once the implementation specific model is obtained, then a model checker or other tool is executed to determine the coverage space of possible states for the interconnect architecture. As stated above, the coverage space may include all the possible states for the implementation model or a reduced set of possible states, such as a symmetrically reduced set of states.

Next in flow **305** to flow **310** a generic test suite is loaded and executed for simulation. In one embodiment, the simulation environment includes a Resistor Transfer Level (RTL) simulation environment. As an example, an RTL environment is created to simulate operation of the architecture during operation. The generic test suite induces/simulates normal actions that may take place to stress different traces and states of the coherence protocol. For example, specific known difficult transactions or configurations may be included in the generic test suite to test that the protocol does not fail during operation. The generic test suite may also include random cases, traffic and activity to enable for random validation of protocol states. Note that a similar simulation of a generic test suite may be utilized for any validation object, such as a physical interconnect layer or other protocol.

In flow **315** feedback based on a plurality of the number of possible states not encountered during execution/simulation of the generic test suite is provided to form a targeted test suite. Here, in flow **316,** the possible architecture states that were not encountered or visited during simulation are determined. In one embodiment, a database similar to database **201** of **Figure 2** is utilized for this determination. As stated above, the database may hold a coverage space of possible states, which may be all the possible states of a validation object or some reduced subset thereof.

As an example, states encountered during simulation are marked in the database. Note that the token ID of database **201** may be utilized to index into the database and mark the correct entry. Therefore, when simulation is complete, all the states visited are marked in database **201.** As a result, any possible state held in database **201** not marked is determined to have not been encountered during simulation.

In flow **317,** a targeted test suite to target possible states not encountered is determined. In one embodiment, the database is queried to determine states not encountered. For example, when a large space of states, i.e. some combination of parameters that are the same, is not encountered, it is often referred to as a hole or gap. As an example, assume a state where a first processor holds a line in a shared state, a second processor holds the line in shared state, and a snoop is received from a third processor is never encountered. Note that a database with 100 parameters only having these three parameters constant would logically create a large number of states not encountered, i.e. every state that includes these parameters and varies the other 97. In other words, a very large gap or hole is produced, as a large number of states with similar parameters was not encountered during simulation to ensure proper operation.

Therefore, in one embodiment, the state information is feed back into the formal mode or other model to determine a trace to get from an initial state to the non-encountered state. In other words, it is determined what needs to occur in the architecture to reach the non-encountered state. This information is then utilized to build a targeted test suite, which potentially induces the trace in simulation to reach the non-encountered states or some portion thereof.

Here, the generic test suite may be modified with the above trace information or other information to target non-encountered states. However, the target test suite does not have to target all of the possible states not encountered. In fact, in an extremely complex interconnect with so many possible states it may be extremely difficult to target every possible state. Consequently, it may be a goal to only reach a confidence level, i.e. a percentage of states validated, rather than encountering all states. Note that there may also be a percentage gap/hole confidence level goal as well to ensure at least some states in a number of holes/gaps are validated. As a result, some user analysis or analysis by a program may determine a subset of the possible states not encountered to target to cover holes, gaps, or corner cases for validation.

As stated above, the target test suite, when executed, is intended to induce or simulate possible architecture states not encountered during execution/simulation of the generic test suite. Furthermore, a subset of the possible states not encountered may be intelligently selected by a physical user or through execution of code to target gaps, holes, corner cases, identified difficult states, or other possible states.

Returning to flow **310,** the targeted test suite is executed/simulated in a similar manner to the generic test suite. Here, the newly encountered states may also be marked off in the database. Furthermore, feedback loop **315** may be recursively repeated to further target other possible states not yet encountered or to re-target possible states that were previously targeted but not encountered during simulation.

Turning to **Figure 4****,** a specific oversimplified illustrative embodiment of a flow diagram for a methodology/strategy for ensuring efficient simulation validation coverage of an architecture is depicted. In flows **405-417** a formal model is filtered based on configuration constraints of a specific embodiment of the architecture, a model checker is run to explore a coverage space of possible states for the filtered implementation specific model, and the coverage space is stored in database **417.**

Note from above, that the coverage space may include all possible architecture states for an architecture/validation object or a reduced set of states, such as a symmetrically reduced set of states. Also, database **417** may resemble database **201** from **Figure 2****,** wherein an entry of the database corresponds to an architecture state of the coverage space. Here, each entry includes at least a plurality of parameter values for parameters of the architecture that define the architecture state that corresponds to the entry, a token identifier (ID) that is based on the plurality of parameter values, and a marking field.

Here, validation and simulation may be performed in parallel, immediately after generating the database, or later. For example, a company providing a specification or model for an architecture, such as a protocol architecture, may in addition or in the alternative, provide the database from flow **417** to a customer to enable efficient simulation and validation of an interconnect. The generic test suite and other code/scripts may also be provided.

Nevertheless, after the database is created and/or provided, in flow **425** a generic test suite from flow **420** is simulated. In the embodiment illustrated, Registor Transfer Level (RTL) simulation is performed. However, any language, code, simulator, or other known simulation/validation tool may be utilized to simulate operation of the architecture. Either during simulation or after simulation, the states of the architecture encountered are marked off in flow **430** within the database of flow **417.** As stated above, a token ID for each state/entry may be utilized to index into database **417.** Note that any other key, such as a generic database key, may instead be utilized to index into the database.

Here, the possible states of the coverage space held in the database not marked are determined, in flow **435,** to not have been encountered/visited during simulation in flow **425.** Based on this determination, a targeted test suite is developed/determined in flow **440** to target possible states of the coverage space not encountered during simulation. As stated above, gaps and holes, as well as other states, may be targeted utilizing automated software and fed back into a model to determine traces/information to target those states. Note that not all of the possible states not encountered may be targeted, as the targeted states may be intelligently selected to encounter corner states, known problematic states, and gaps/holes in state coverage, as well as some number of randomly targeted states to provide additional coverage. The targeted test suite is then utilized in simulation flow **425** and database entries/states that are newly encountered are marked off. This process may be performed recursively until adequate validation coverage of the possible states is achieved.

Therefore, as can be seen from above, an efficient and automated validation methodology for a complex architecture, such as complex protocols, complex interconnects, and other complex validation objects, is herein described. Previously, protocols and interconnects were less complex allowing for a user to comprehend the coverage space and provide adequate test suites to ensure confidence during validation. However, through use of a database to hold a coverage space of architecture states, a complex architecture is able to be comprehended in electronic format. Furthermore, by marking states encountered during simulation, the number of states encountered and not encountered is also capable of being comprehended. Based on this, a targeted test suite may be developed to ensure adequate validation of the coverage space is achieved. As a result, not only may a validation confidence level of an architecture be comprehended, it may also be achieved through recursive targeting of non-simulated states.

A value, as used herein, includes any known representation of a number, a state, a logical state, or a binary logical state. Often, the use of logic levels, logic values, or logical values is also referred to as 1's and 0's, which simply represents binary logic states. For example, a 1 refers to a high logic level and 0 refers to a low logic level. In one embodiment, a storage cell, such as a transistor or flash cell, may be capable of holding a single logical value or multiple logical values. However, other representations of values in computer systems have been used. For example the decimal number ten may also be represented as a binary value of 1010 and a hexadecimal letter A. Therefore, a value includes any representation of information capable of being held in a computer system.

Moreover, states may be represented by values or portions of values. As an example, a first value, such as a logical one, may represent a default or initial state, while a second value, such as a logical zero, may represent a non-default state. In addition, the terms reset and set, in one embodiment, refer to a default and an updated value or state, respectively. For example, a default value potentially includes a high logical value, i.e. reset, while an updated value potentially includes a low logical value, i.e. set. Note that any combination of values may be utilized to represent any number of states.

The embodiments of methods, hardware, software, firmware or code set forth above may be implemented via instructions or code stored on a machine-accessible or machine readable medium which are executable by a processing element. A machine-accessible/readable medium includes any mechanism that provides (i.e., stores and/or transmits) information in a form readable by a machine, such as a computer or electronic system. For example, a machine-accessible medium includes random-access memory (RAM), such as static RAM (SRAM) or dynamic RAM (DRAM); ROM; magnetic or optical storage medium; flash memory devices; electrical storage device, optical storage devices, acoustical storage devices or other form of propagated signal (e.g., carrier waves, infrared signals, digital signals) storage device; etc.. For example, a machine may access a storage device through receiving a propagated signal, such as a carrier wave, from a medium capable of holding the information to be transmitted on the propagated signal.

Reference throughout this specification to "one embodiment" or "an embodiment" means that a particular feature, structure, or characteristic described in connection with the embodiment is included in at least one embodiment of the present invention. Thus, the appearances of the phrases "in one embodiment" or "in an embodiment" in various places throughout this specification are not necessarily all referring to the same embodiment. Furthermore, the particular features, structures, or characteristics may be combined in any suitable manner in one or more embodiments.

In the foregoing specification, a detailed description has been given with reference to specific exemplary embodiments. It will, however, be evident that various modifications and changes may be made thereto without departing from the broader spirit and scope of the invention as set forth in the appended claims. The specification and drawings are, accordingly, to be regarded in an illustrative sense rather than a restrictive sense. Furthermore, the foregoing use of embodiment and other exemplarily language does not necessarily refer to the same embodiment or the same example, but may refer to different and distinct embodiments, as well as potentially the same embodiment.

## Claims

1. An apparatus comprising:
a storage medium holding a coverage database, the coverage database including a first number of entries that correspond to a first number of possible states of an architecture, wherein one entry of the first number of entries corresponding to one possible state of the plurality of possible states includes a plurality of parameter values, each of the parameter values to represent a value of an associated parameter of the architecture for the one possible state.

2. The apparatus of claim 1, wherein the one entry of the first number of entries further includes a token identifier, the token identifier being based on a algorithmic combination of the plurality of parameter values, optionally, wherein the one entry of the first number of entries further includes a marking field to be updated to a marked value in response to Register Transfer Level (RTL) simulation encountering the one possible state.

3. The apparatus of any preceding claim, wherein the plurality of parameter values are grouped in the one entry of the first number of entries in a global group of parameter values of the plurality of parameter values and a plurality of agent groups of parameter values of the plurality of parameter values, and wherein the global group of parameter values are to correspond to global parameters of the architecture and each of the plurality of agent groups of parameter values include agent specific parameter values of the architecture; or wherein the architecture includes a protocol architecture, the protocol architecture to be selected from a group consisting of a cache coherence protocol architecture, a transaction layer protocol architecture, a link layer protocol architecture, an interconnect protocol architecture, a wireless communication protocol architecture.

4. The apparatus of any preceding claim, wherein the associated parameter is independently selected from a group consisting of different types of agents, agent responses, device responses, interconnect responses, message responses, types of responses, other responses to specific actions, response destinations, messages, types of messages, message destinations, requests, types of requests, request destinations, types of caches, cache states, cache locations, register states; optionally wherein the first number of possible states includes every state explored during execution of a model checker to check a model of the architecture, or wherein the first number of possible states includes a symmetrically reduced set of every state explored during execution of a model checker model to check a model of the architecture.

5. An article of manufacture including program code which, when executed by a machine, causes the machine to perform the operations of:
determining a first number of states held in a reference database for a protocol implementation that are not visited during simulation of a generic test suite for the protocol implementation; and
developing a targeted simulation test suite, when simulated for the protocol implementation, to target a plurality of the first number of states that are not visited during simulation of the generic test suite.

6. The article of manufacture of claim 5, wherein determining a first number of states held in a reference database for a protocol implementation that are not visited during simulation of a generic test suite for the protocol implementation comprises:
simulating the generic test suit for the protocol implementation;
marking a second number of states held in the reference database that are visited during simulation of the generic test suit;
determining that the first number of states held in the reference database are not visited during simulation of the generic test suit in response to the first number of states not being marked after marking the second number of states during simulation of the generic test suit.

7. The article of manufacture of claim 9, wherein developing a targeted simulation test suite, when simulated for the protocol implementation, to target a plurality of the first number of states that are not visited during simulation of the generic test suite comprises:
identifying the plurality of the first number of states that are not visited during simulation of the generic test suite,
determining a plurality of traces from an initial state to the plurality of the first number of states that are not visited during simulation of the generic test suite; and building the plurality of traces in the targeted simulation test suite, when simulated for the protocol implementation, to target the plurality of the first number of states, preferably, wherein identifying the plurality of the first number of states that are not visited during simulation of the generic test suite is in response to an automated query of the reference database; or wherein the program code which, when executed by the machine, further causes the machine to perform the operations of:
simulating the targeted simulation test suite; and
marking the plurality of the first number of states held in the reference database that are visited during simulation of the targeted simulation test suite.

8. An article of manufacture including program code which, when executed by a machine, causes the machine to perform the operations of:
determining a coverage space of possible states for a validation object based on a plurality of parameters for the validation object;
calculating a corresponding token identifier for a possible state within the coverage space of possible states based on a plurality of corresponding values that correspond to the plurality of parameters for the possible state; and
storing the corresponding token identifier and the plurality of corresponding values for the possible state in an entry of a database.

9. The article of manufacture of claim 8, wherein the validation object is selected from a group of a communication protocol, a networking protocol, a wireless protocol, a coherence protocol, an interconnect protocol, and a physical interconnect architecture; or further comprising:
simulating a generic test suite for the validation object;
marking the entry of the database associated with the possible state in response to encountering the possible state during simulating the generic test suite for the validation object; and
providing a targeted test suite, when simulated for the validation object, to target the possible state in response to the entry of the database not being marked after simulating the generic test suite; or wherein determining a coverage space of possible states for a validation object based on a plurality of interconnect parameters comprises:
tailoring a formal model of the validation object based on a plurality of configuration constraints for the validation object;
executing a model checker to explore all possible states for the validation object through variance of the plurality of parameters to form the coverage space of possible states' preferably, wherein calculating a corresponding token identifier for a possible state within the coverage space of possible states based on a plurality of corresponding values that correspond to the plurality of parameters for the possible state comprises: combining the plurality of corresponding values using an algorithm to obtain the corresponding token identifier.

10. A method comprising:
determining a plurality of possible states of an architecture;
calculating an identifier for each of the plurality of possible states based on numerical parameters for each of the plurality of possible states; and
storing the identifier for each of the plurality of possible states and the numerical parameters for each of the plurality of possible states in a database.

11. The method of claim 10, wherein determining a plurality of possible states of an architecture comprises: filtering a formal model based on a plurality of configuration constraints to form an implementation model for the architecture and performing a model check on the implementation model to determine the plurality of possible states for the architecture; or wherein determining a plurality of possible states of an architecture comprises filtering a formal model based on a plurality of configuration constraints to form an implementation model for the architecture, performing a model check on the implementation model to determine all of the possible states for the architecture, and reducing a plurality of symmetrical states of all of the possible states to determine the plurality of possible states; or wherein calculating an identifier for each of the plurality of possible states based on numerical parameters for each of the plurality of possible states comprises combining the numerical parameters for each of the plurality of possible states utilizing a predefined mathematical algorithm to calculate the identifier for each of the plurality of possible states.

12. A method comprising:
determining a number of possible states for an architecture;
executing a generic test suite to simulate operation of the architecture; and
providing feedback based on a plurality of the number of possible states not encountered during executing the generic test suite to form a targeted test suite, the targeted test suite, when executed, to target the plurality of the number of possible states not encountered during executing the generic test suite.

13. The method of claim 12, wherein the architecture includes a protocol architecture, the protocol architecture to be selected from a group consisting of an interconnect communication protocol architecture, a cache coherency protocol architecture, a network communication protocol architecture, and a wireless communication protocol architecture, or wherein determining a number of possible states of an architecture comprises:
filtering a formal model for the architecture to an implementation specific model of the architecture based on a plurality of configuration constraints; and
executing a model checker to determine the number of possible states of the implementation specific model for the architecture.

14. The method of claim 12, further comprising: storing a representation of each of the number of possible states in an entry of the database, wherein each entry of the database is to include a parameter field to hold a plurality of numerical values associated with a plurality of parameters that define a possible state of the number of possible states associated with the entry, a token identifier field to hold a token identifier based on the plurality of numerical values, and a marking field, when updated to a marked value, to indicate the possible state has been encountered during executing the generic test suite.

15. The method of claim 14, wherein providing feedback based on a plurality of the number of possible states not encountered during executing the generic test suite to form a targeted test suite, the targeted test suite, when executed, to target the plurality of the number of possible states not encountered during executing the generic test suite comprises:
updating the marking field of each entry of the database to a marked value in response to encountering the possible state of the number of states during executing the generic test suite;
determining the plurality of the number of possible states not encountered based on the marking field associated with each of the plurality of the number of possible states holding an unmarked value; and
modifying the generic test suite to form the targeted test suite.
